# EUROPEAN PATENT SPECIFICATION

(11) **EP 4 543 179 B1**
(45) Date of publication and mention of the grant of the patent: **10.06.2026**
(21) Application number: 23850196.9
(22) Date of filing: 05.04.2023
(51) Int. Cl.: H10K 59/65, H10K 59/35, H10K 50/813, H10K 50/86, H04M 1/02, H10K 50/11

(54) **ELECTRONIC DEVICE HAVING STRUCTURE IN WHICH CAMERA IS DISPOSED UNDER DISPLAY**
ELEKTRONISCHE VORRICHTUNG MIT STRUKTUR, IN DER EINE KAMERA UNTER DER ANZEIGE ANGEORDNET IST
DISPOSITIF ÉLECTRONIQUE AYANT UNE STRUCTURE DANS LAQUELLE UNE CAMÉRA EST PLACÉE SOUS UN ÉCRAN

(30) Priority: 01.08.2022 KR 20220095483; 14.09.2022 KR 20220115772
(43) Date of publication of application: 23.04.2025
(73) Proprietor: Samsung Electronics Co., Ltd., Suwon-si, Gyeonggi-do 16677 (KR)
(72) Inventor: SHIN, Sungyoung, Suwon-si, Gyeonggi-do 16677 (KR); UHM, Minsuk, Suwon-si, Gyeonggi-do 16677 (KR); LEE, Dongseop, Suwon-si, Gyeonggi-do 16677 (KR); LEE, Haechang, Suwon-si, Gyeonggi-do 16677 (KR); KIM, Kwangtai, Suwon-si, Gyeonggi-do 16677 (KR); YEOM, Donghyun, Suwon-si, Gyeonggi-do 16677 (KR)
(74) Representative: Gulde & Partner
(86) International application number: PCT/KR2023/004573
(87) International publication number: WO 2024/029683

(56) References cited:
- KR-A- 20220 032 399
- KR-A- 20220 044 173
- KR-A- 20220 089 825
- US-A1- 2018 088 260
- US-A1- 2019 355 794
- US-A1- 2021 376 008
- US-A1- 2022 077 248
- US-A1- 2022 199 702

## Description

### [Technical Field]

The disclosure relates to an electronic device having a structure in which a camera is disposed under a display.

### [Background Art]

Electronic devices (e.g., smartphones) may include a large-screen touch-sensitive display for wide visibility and easy manipulation. According to the need for a large screen, the display may expand across the entire front surface of the electronic device, and a camera may be disposed under the display.

The camera disposed under the display and receiving light through the display may be referred to as an under-display camera (UDC).

The above information may be provided as related art for the purpose of helping to understand the disclosure. No claim or determination is made as to whether any of the above is applicable as prior art in connection with the disclosure.

US 2022/199702 A1 discloses a conventional device.

### [Disclosure of Invention]

### [Technical Problem]

Light may be diffracted by a microstructure in which pixels repeat in the display. This diffraction may cause light spreading and/or splitting. The quality of an image captured by the UDC may deteriorate due to the diffraction of light.

According to various embodiments, the electronic device may have a pixel structure capable of reducing the light spreading or splitting and increasing the resolution of the UDC. Accordingly, the image quality of the UDC may be improved.

The technical problems to be solved in the disclosure are not limited to the technical problems mentioned above, and other technical problems not mentioned may be clearly understood by those skilled in the art to which this document pertains from the description below.

### [Solution to Problem]

The present invention is set out the appended set of claims.

According to an embodiment, an electronic device may include a camera; and a display disposed between a subject to be captured by the camera and the camera. When facing a front surface of the display, the display may include a camera region disposed above the camera when facing a front surface of the display. Subpixels may be disposed within the camera region, when facing a front surface of the display, such that a first G subpixel, a second G subpixel, a third G subpixel, and a fourth G subpixel are positioned at vertexes of a quadrangle, respectively, such that a first R subpixel and a second R subpixel are positioned at opposite first and second edges, respectively, in the quadrangle, such that a first B subpixel and a second B subpixel are positioned at opposite third and fourth edges, respectively, in the quadrangle, and such that no subpixel exists within the quadrangle. The first R subpixel and the second R subpixel may be configured in the shape of an ellipse. A long axis of the ellipse may extend parallel to the first edge in the first R subpixel. A long axis of the ellipse may extend parallel to the second edge in the second R subpixel. The first B subpixel and the second B subpixel may be configured in the shape of an ellipse. A long axis of the ellipse may extend parallel to the third edge in the first B subpixel. A long axis of the ellipse may extend parallel to the fourth edge in the second B subpixel. The first G subpixel, the second G subpixel, the third G subpixel, and the fourth G subpixel may be configured in the shape of a cross. Concave portions of the cross may face the first R subpixel, the second R subpixel, the first B subpixel, or the second B subpixel.

According to an embodiment, an electronic device may include a camera; and a display disposed between a subject to be captured by the camera and the camera. The display may include a camera region disposed above the camera when facing a front surface of the display. Subpixels may be disposed within the camera region, when facing the front surface of the display, such that a first G subpixel, a second G subpixel, a third G subpixel, and a fourth G subpixel are positioned at vertexes of a quadrangle, respectively, such that a first R subpixel and a second R subpixel are positioned at opposite first and second edges, respectively, in the quadrangle, such that a first B subpixel and a second B subpixel are positioned at opposite third and fourth edges, respectively, in the quadrangle, and such that no subpixel exists within the quadrangle. The first R subpixel and the second R subpixel may be configured in the shape of an ellipse. A long axis of the ellipse may extend parallel to the first edge in the first R subpixel. A long axis of the ellipse may extend parallel to the second edge in the second R subpixel. The first B subpixel and the second B subpixel may be configured in the shape of an ellipse. A long axis of the ellipse may extend parallel to the third edge in the first B subpixel. A long axis of the ellipse may extend parallel to the fourth edge in the second B subpixel. The first G subpixel, the second G subpixel, the third G subpixel, and the fourth G subpixel may be configured in the shape of a cross. Concave portions of the cross may face the first R subpixel, the second R subpixel, the first B subpixel, or the second B subpixel. When facing the front surface of the display, a light blocking membrane may be formed in all areas, excluding a light transmitting area surrounded by subpixels, under the subpixels within the camera region.

### [Advantageous Effects of Invention]

Various embodiments may provide an electronic device having a pixel structure capable of reducing the light spreading or splitting and increasing the resolution of UDC. The effects obtainable from the disclosure are not limited to the effects mentioned above, and other effects that are not mentioned will be clearly understood by those skilled in the art to which the disclosure pertains from the description below.

### [Brief Description of Drawings]

FIG. 1 is a block diagram of an electronic device in a network environment according to various embodiments.
FIG. 2 is a block diagram illustrating a camera module according to various embodiments.
FIG. 3A is a perspective view illustrating a front surface of an electronic device having a structure in which a front camera is disposed under a display according to an embodiment.
FIG. 3B is a perspective view illustrating a rear surface of the electronic device in FIG. 3A.
FIG. 3C is a cross-sectional view of a portion of the display facing a front camera, which is cut in the z-axis direction.
FIG. 4A is a diagram illustrating a pixel structure of a camera region in a display according to an embodiment.
FIG. 4B is a cross-sectional view of the camera region taken along line AB in the z-axis direction in FIG. 4A.
FIG. 4C is a cross-sectional view of the camera region taken along line CD in the z-axis direction in FIG. 4A.
FIG. 5A is a diagram illustrating a pixel structure of a camera region having a light blocking film according to an embodiment.
FIG. 5B is a cross-sectional view of the camera region taken along line EF in the z-axis direction in FIG. 5A.
FIG. 5C is a cross-sectional view of the camera region 500 taken along line GH in the z-axis direction in FIG. 5A.

### [Mode for the Invention]

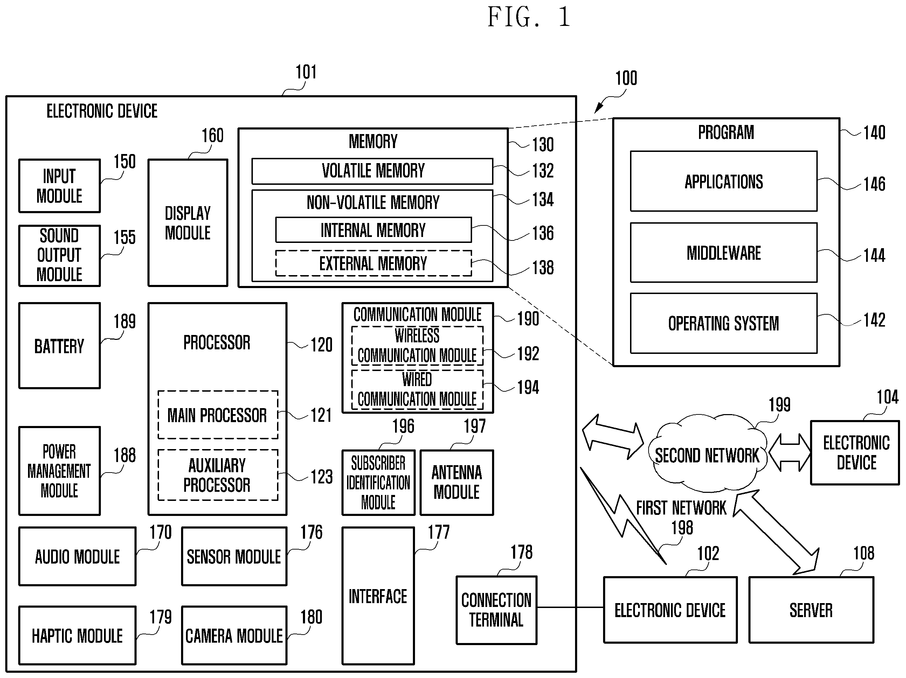

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

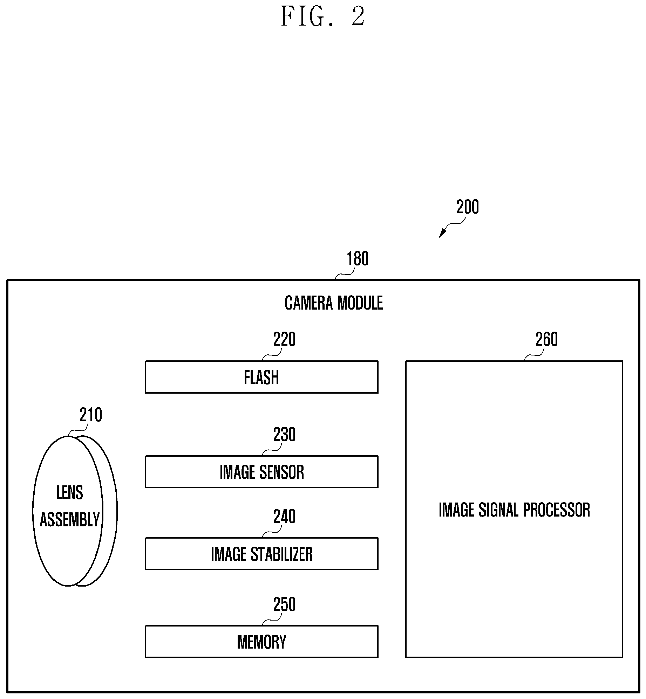

Fig. 2 is a block diagram 200 illustrating the camera module 180 according to various embodiments. Referring to Fig. 2, the camera module 180 may include a lens assembly 210, a flash 220, an image sensor 230, an image stabilizer 240, memory 250 (e.g., buffer memory), or an image signal processor 260.

The lens assembly 210 may collect light emitted or reflected from an object whose image is to be taken. The lens assembly 210 may include one or more lenses. According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light reflected from an object. According to an embodiment, the flash 220 may include one or more light emitting diodes (LEDs) (e.g., a red-green-blue (RGB) LED, a white LED, an infrared (IR) LED, or an ultraviolet (UV) LED) or a xenon lamp.

The image sensor 230 may obtain an image corresponding to an object by converting light emitted or reflected from the object and transmitted via the lens assembly 210 into an electrical signal. According to an embodiment, the image sensor 230 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect (e.g., image blurring) by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer.

The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display module 160. Thereafter, if a specified condition is met (e.g., by a user's input or system command), at least part of the raw image stored in the memory 250 may be obtained and processed, for example, by the image signal processor 260. According to an embodiment, the memory 250 may be configured as at least part of the memory 130 or as a separate memory that is operated independently from the memory 130.

The image signal processor 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 260 may perform control (e.g., exposure time control or read-out timing control) with respect to at least one (e.g., the image sensor 230) of the components included in the camera module 180. An image processed by the image signal processor 260 may be stored back in the memory 250 for further processing, or may be provided to an external component (e.g., the memory 130, the display module 160, the electronic device 102, the electronic device 104, or the server 108) outside the camera module 180. According to an embodiment, the image signal processor 260 may be configured as at least part of the processor 120, or as a separate processor that is operated independently from the processor 120. If the image signal processor 260 is configured as a separate processor from the processor 120, at least one image processed by the image signal processor 260 may be displayed, by the processor 120, via the display module 160 as it is or after being further processed.

According to an embodiment, the electronic device 101 may include a plurality of camera modules 180 having different attributes or functions. In such a case, at least one of the plurality of camera modules 180 may form, for example, a wide-angle camera and at least another of the plurality of camera modules180 may form a telephoto camera. Similarly, at least one of the plurality of camera modules 180 may form, for example, a front camera and at least another of the plurality of camera modules180 may form a rear camera.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

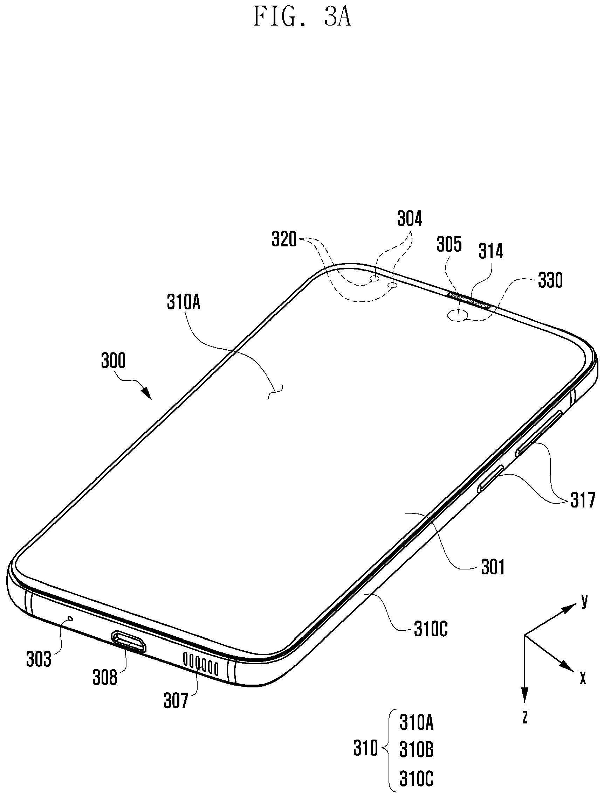

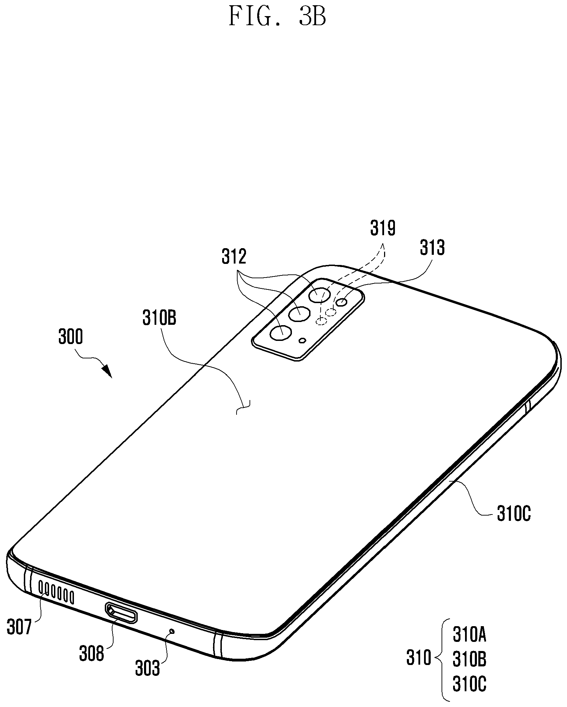

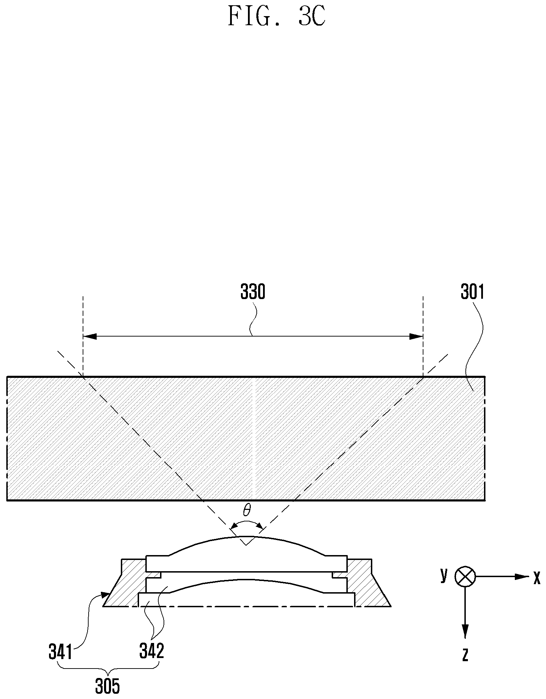

FIG. 3A is a perspective view illustrating a front surface of an electronic device 300 having a structure in which a front camera 305 is disposed under a display 301 according to an embodiment. FIG. 3B is a perspective view illustrating a rear surface of the electronic device 300 in FIG. 3A. FIG. 3C is a cross-sectional view of a portion of the display 301 facing a front camera 305, which is cut in the z-axis direction.

Referring to FIGS. 3A and 3B, a housing 310 of the electronic device 300 (e.g., the electronic device 101 in FIG. 1) according to an embodiment may include a first surface (or front surface) 310A, a second surface (or rear surface) 310B, and a side surface 310C surrounding a space between the first surface 310A and the second surface 310B. In an embodiment, the first surface 310A may be configured as a front plate (e.g., a glass plate including various coating layers, or a polymer plate) (or a front cover) that is at least partially transparent. The second surface 310B may be configured as a rear plate (or a rear cover) that is substantially opaque. The side surface 310C may be configured as a side bezel structure (or a side member) that is coupled to the front plate and the rear plate and includes metal and/or polymer.

According to an embodiment, the electronic device 300 may include one or more of a display 301, a microphone hole 303, speaker holes 307 and 314, sensor modules 304 and 319, camera modules 305, 312, and 313, a key input device 317, and a connector 308. In a certain embodiment, the electronic device 300 may exclude at least one (e.g., the key input device 317) of the components or may further include other components.

In an embodiment, the display 301 (e.g., the display module 160 in FIG. 1) may be exposed through the first surface 310A. The display 301 may be combined with or disposed adjacent to a touch detection circuit, a pressure sensor capable of measuring the intensity (pressure) of a touch, and/or a digitizer for detecting a stylus pen of a magnetic field type.

Hereinafter, in this document, the surface on which the display 301 (e.g., a main display) is disposed will be defined as a front surface of the electronic device 300, and the surface opposite the front surface will be defined as a rear surface of the electronic device 300. In a certain embodiment, a separate display (e.g., an auxiliary display) may be disposed on the rear surface. Accordingly, the display disposed on the front surface may be referred to as a front display, and the display placed on the rear surface may be referred to as a rear display.

In an embodiment, the electronic device (e.g., the electronic device 101 in FIG. 1) may have a foldable housing structure, rather than the bar-type housing structure illustrated in FIG. 3A. The foldable housing structure may be divided into two housings based on a folding axis. A first part of the front display (e.g., a flexible display) may be disposed on a front surface of a first housing, and a second part of the display may be disposed on a front surface of a second housing. The foldable housing structure may be implemented in an in-folding manner in which the first part and the second part of the front display face each other when the electronic device is in a folded state. Alternatively, the foldable housing structure may be implemented in an out-folding manner in which the first part and the second part of the front display face in the opposite directions when the electronic device is in a folded state. A second display may be disposed on the rear surface of the first housing and/or the rear surface of the second housing. As another example, the electronic device may have a slidable housing structure. For example, the electronic device may include a housing, a slider part, and a rollable and flexible display (e.g., a front display) enables a portion of the slider part to be received inside the housing or exposed outside the housing.

In an embodiment, the sensor modules 304 and 319 (e.g., the sensor module 176 in FIG. 1) may generate electrical signals or data in response to an operating state inside the electronic device 300 or an external environmental state. In an embodiment, the sensor modules 304 and 319 may include a first sensor module 304 disposed on the first surface 310A and/or a second sensor module 319 (e.g., an optical sensor and/or a heart rate monitoring (HRM) sensor) disposed on the second surface 310B. The first sensor module 304 may be disposed under the display 301 when viewing the display 301 from above the first surface 310A. For example, referring to FIG. 3A, an upper portion of the display 301 may be designated as a sensor area (or first sensor area) 320 and an optical sensor (e.g., a photodiode) may be disposed under the same. The optical sensor disposed under the sensor area 320 may include a light-source recognition sensor (e.g., an ambient light sensor (ALS) or a flicker sensor) for recognizing the type of light source (e.g., an artificial light source or the sun) and/or an illuminance sensor for measuring the surrounding illuminance of the electronic device 300. The optical sensor disposed under the sensor area 320 may also include a proximity sensor for recognizing an object approaching the electronic device 300 and calculating the distance between the electronic device 300 and the object adjacent thereto. The first sensor module 304 may generate an electric signal (e.g., a current) in response to light transmitted through the sensor area 320, and may convert the electric signal into a digital signal and output the same to a processor (e.g., the processor 120 in FIG. 1). A lower portion of the display 301 may be further designated as a sensor area and a fingerprint sensor may be disposed under the same. For example, the processor may cause pixels positioned in the sensor area to emit light, and may obtain fingerprint information using information of light that is reflected on a fingertip adjacent to the sensor area and received by a fingerprint sensor. The fingerprint sensor may include image sensors arranged in two dimension under the sensor area and a lens disposed between the sensor area and the image sensors.

In an embodiment, the camera modules 305, 312, and 313 (e.g., the camera module 180 in FIG. 1) may include a front camera 305 disposed on the first surface 310A, and a rear camera 312 and a flash 313 disposed on the second surface 310B. The cameras 305 and 312 may include a lens assembly (including one or more lenses), an image sensor, and/or an image signal processor. The flash 313 may include, for example, a light-emitting diode or a xenon lamp. In a certain embodiment, two or more lenses (e.g., a wide-angle lens, an ultra-wide-angle lens, or a telephoto lens) and image sensors may be disposed on one surface of the electronic device 300. In an embodiment, the front camera 305 may be an under-display camera (UDC) that is disposed under the display 301 when viewing the display 301 from above the first surface 310A and receives light through the display 301. For example, referring to FIG. 3A, a camera region (or a second sensor area 330) may be positioned on the edge (e.g., upper portion) of the display 301 and the front camera 305 may be disposed under the same. In an embodiment, the front camera 305 may be disposed in the inner space of the electronic device 300 to perform its function without being visually exposed through the display 301.

In an embodiment, the second sensor area 330 of the display 301 may be formed as a transparent area having a specified transmittance. According to an embodiment, the transparent area may be configured to have a transmittance in the range of about 5% to about 25%. Alternatively, the transparent area may be configured to have a transmittance in the range of about 25% to about 50%. The transparent area may include an area overlapping an effective area (e.g., the area of an angle of view) of the front camera 305 through which light, which is to reach the image sensor to produce an image, passes. For example, the transparent area of the display 301 may include an area having a lower pixel density and/or wire density than the surrounding area.

In an embodiment, the transparent area may be an area having an increased light transmittance due to a method in which wires or driving circuits are disposed differently from other areas of the display, a method in which the transparency or reflectivity of an electrode passing through the transparent area is formed differently from other areas of the display, or a method in which a polarizing plate is removed from the transparent area, unlike other areas of the display. In addition, the transparent area may include an area to which various methods are applied in order to increase light transmittance, compared to other areas of the display.

In an embodiment, a hole (e.g., a punch hole) (or an opening) may be formed in the camera region 330 facing the front camera 305 in the display 301. For example, the display 301 may be configured in multiple layers (e.g., a polarizing film, a display panel, and material layers (e.g., a light blocking layer for blocking light generated from the display panel or light incident on the display panel from the outside, a heat dissipation sheet, and a sponge)), and a through-hole may be formed on the remaining layers, excluding at least one layer (e.g., the display panel), in the camera region 330. At least a portion (e.g., a lens) of the front camera 305 may be disposed in the inner space of the hole formed in the camera region 330. Although not illustrated in the drawing, in a certain embodiment, a plurality of front cameras may be disposed under the display 301. The electronic device (e.g., the electronic device 101 in FIG. 1) may include a rear display. Accordingly, a UDC that receives light through the rear display may be further disposed under the rear display.

Referring to FIG. 3C, a front camera 305 may be disposed under the camera region 330 of the display 301. The front camera 305 may be configured to include a lens housing 341 and a lens assembly 342 disposed therein. According to an embodiment, the size (e.g., diameter) of the camera region 330 may be determined based on a preconfigured angle of view (θ) of the lens assembly 342. Light passing through the camera region 330 may converge onto an image sensor (not shown) of the front camera 305 by the lens assembly 342. The image sensor may generate an electric signal (e.g., current) in response to the light and process the electric signal (e.g., analog-to-digital conversion (ADC)), thereby producing an image.

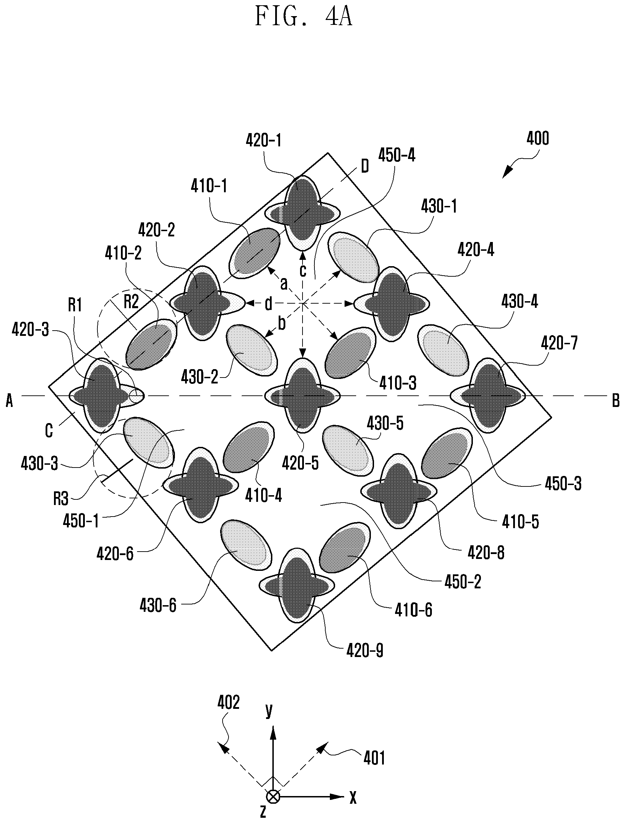

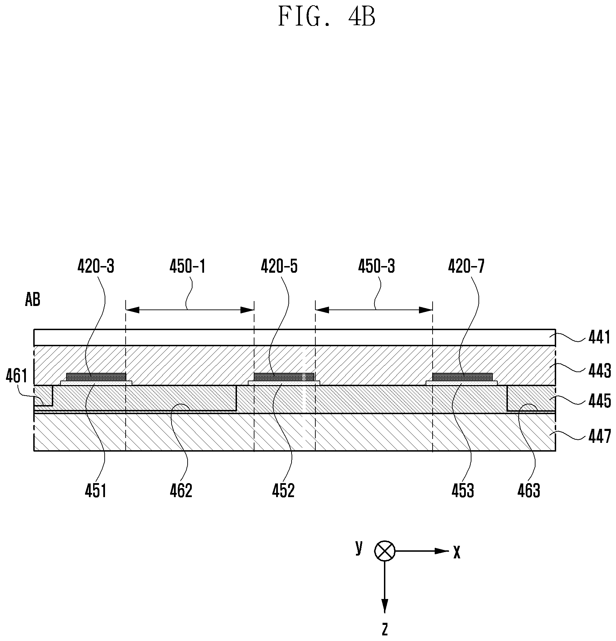

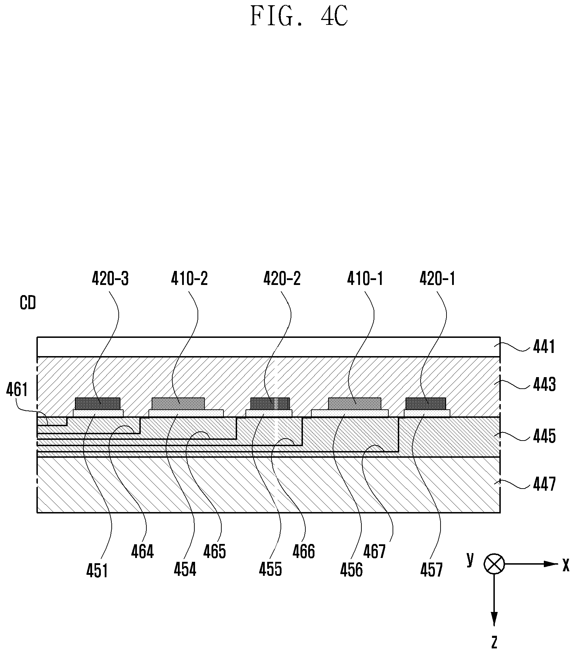

FIG. 4A is a diagram illustrating a pixel structure of a camera region 400 in a display according to an embodiment. FIG. 4B is a cross-sectional view of the camera region 400 taken along line AB in the z-axis direction in FIG. 4A. FIG. 4C is a cross-sectional view of the camera region 400 taken along line CD in the z-axis direction in FIG. 4A. The camera region 400 may correspond to, for example, a part of the camera region 330 in FIG. 3A. The pixel structure of the camera region 330 may be the same as (or similar to) the pixel structure illustrated in FIG. 4A.

Referring to FIG. 4A, when facing the front surface (e.g., the xy plane), RGB subpixels may be disposed in the camera region 400 such that four green (G) subpixels are positioned at respective vertexes of a quadrangle (e.g., a square or a rhombus), such that two red (R) subpixels are positioned at two opposite edges, such that two blue (B) subpixels are positioned at two other opposite edges, and such that no subpixel exists inside the quadrangle. Here, the inside of the quadrangle may be defined as an area (e.g., a light transmitting area or an aperture area) between two B subpixels positioned at two opposite edges, between two R subpixels positioned at two other opposite edges, or between two G subpixels positioned at vertexes that are not adjacent to each other. External light may pass through the light transmitting area to reach the camera (e.g., the front camera 305).

Continuing with reference to FIG. 4A, R subpixels 410-1, 410-2, 410-3, 410-4, 410-5, and 410-6 and G subpixels 420-1, 420-2, 420-3, 420-4, 420-5, 420-6, 420-7, 420-8, and 420-9 may be disposed alternately in the first direction 401 inside the camera region 400. B subpixels 430-1, 430-2, 430-3, 430-4, 430-5, and 430-6 and the G subpixels 420-1, 420-2, 420-3, 420-4, 420-5, 420-6, 420-7, 420-8, and 420-9 may be disposed alternately in the second direction 402 inside the camera region 400. The second direction 402 is a different from the first direction 401 and may be, for example, orthogonal to the first direction 401.

In an embodiment, the number of pixels per unit area may be required to be increased in order to improve the resolution of the camera region 400. The number of pixels may be increased to an extent that adjacent subpixels are not shorted. The increase in the number of pixels may lead to a reduction in the light transmitting area. According to an embodiment, the camera region 400 may have a pixel structure (the quadrangle structure described above) and a pixel shape to increase the light transmitting area without (or while minimizing) the resolution degradation. Referring to FIG. 4A, the R subpixels 410-1, 410-2, 410-3, 410-4, 410-5, and 410-6 may be formed in the shape of an ellipse on the substrate such that the major axis (relatively long axis), rather than the minor axis (relatively short axis), of the ellipse is directed to the first direction 401 in order to increase the size of the light transmitting area (e.g., the distance between two R subpixels positioned at two opposite edges). In other words, the elliptical R subpixel may be formed on the substrate such that the long axis (major axis) thereof extends substantially parallel to the edge at which the corresponding R subpixel is positioned. The B subpixels 430-1, 430-2, 430-3, 430-4, 430-5, and 430-6 may also be formed in the shape of an ellipse on the substrate such that the major axis, rather than the minor axis, of the ellipse is directed to the second direction 402 in order to increase the size of the light transmitting area (e.g., the distance between two B subpixels positioned at two other opposite edges). In other words, the elliptical B subpixel may be formed on the substrate such that the long axis (major axis) thereof extends parallel to the edge at which the corresponding B subpixel is positioned. The G subpixels 420-1, 420-2, 420-3, 420-4, 420-5, 420-6, 420-7, 420-8, and 420-9 may be formed substantially in the shape of a cross on the substrate in order to increase their size. Concave portions of the cross may face the B subpixel having an elliptical shape or the R subpixel having an elliptical shape. Convex portions of the cross may face the light transmitting area. The cross shown in FIG. 4A has a convex portion having a rounded end, but the convex portion may be configured in an angular shape. The R subpixel and G subpixel illustrated in FIG. 4A have an elliptical shape, but they may have angular corners (e.g., a rectangle).

The pixel structure illustrated in FIG. 4A may provide an increase in the light transmitting area without (or while minimizing) degradation of the display resolution. The resolution of the UDC may be improved by the increase in the light transmitting area. For example, lp/mm (line pairs per millimeter) is a measure of the number of identifiable stripes (e.g., a pair of black and white lines extending vertically, horizontally, or diagonally) within a unit width (e.g., 1 mm), and this measure may be increased by the pixel structure illustrated in FIG. 4A.

Referring back to FIG. 4A, the radius of curvature R1 of the convex portion of the cross-shaped G subpixel electrode may be less than the radius of curvature R2 of the long axis of the elliptical R subpixel electrode and the radius of curvature R3 of the long axis of the elliptical B subpixel electrode. Accordingly, the light transmitting area may be increased. In other words, the curvature of the convex portion of the G subpixel electrode may be larger than the curvature of the long axis of the R subpixel electrode and the curvature of the long axis of the B subpixel electrode. The curvature of the long axis of the R subpixel electrode may be substantially the same as the curvature of the long axis of the B subpixel electrode.

In an embodiment, an electrode (e.g., anode) disposed below the subpixel may also be formed on the substrate to have the same shape as the corresponding subpixel. The electrode may have substantially the same size as the corresponding subpixel. The electrode may be formed on the substrate to be larger than the size of the subpixel. For example, when facing the front surface (e.g., the xy plane), the entire portion of the subpixel may be formed within the corresponding electrode.

Continuing with reference to FIG. 4A, the distance a between the electrodes of two R subpixels positioned at two edges, the distance b between the electrodes of two B subpixels positioned at two edges, the distance c between the electrodes of two G subpixels positioned at first and third vertexes, respectively, which are not adjacent to each other, and the distance d between the electrodes of two G subpixels positioned at second and fourth vertexes, respectively, which are not adjacent to each other, may be the same. The disclosure is not limited thereto, and the distances a, b, c, and d may be different. For example, a and b may be the same, and d may be shorter than c.

In an embodiment, the sensor area (e.g., the sensor area designated for obtaining fingerprints on the display) may also have the pixel structure and shapes illustrated in FIG. 4A.

In an embodiment, a combination of adjacent RGB subpixels may constitute one unit of light-emitting elements (pixels). In addition to RGB, pixels configured as a combination of RGBG, pixels configured as a combination of RGBW (white), or the like may also constitute a unit of light-emitting elements. The pixels may be arranged on the display in a stripe structure, a pentile structure, a diamond structure, or a diamond pentile structure. According to an embodiment, a unit of light-emitting elements may be configured as a combination of RGB in the camera region 400, and a unit of light-emitting elements may be configured as a combination of RGBG in the remaining display area (hereinafter, a general area), excluding the camera region 400 (additionally, the sensor area). An area where G is removed from the RGBG combination may be the light transmitting area in the camera region 400. Therefore, the number of G subpixels in the camera region 400 is smaller than the number of G subpixels in the general area. As a compensation for this, the size of the G subpixel in the camera region 400 may be larger than the size of the G subpixel in the general area. The shape for size enlargement may be a cross shown in FIG. 4A. The size of the R subpixel in the camera region 400 may be the same as the size of the R subpixel in the general area outside the camera region 400. The size of the B subpixel in the camera region 400 may be the same as the size of the B subpixel in the general area. In order to increase the light transmitting area associated with the performance of the camera even if the lifespan is shortened to some extent, the size of the R subpixel in the camera region 400 may be smaller than the size of the R subpixel in the general area, and the size of the B subpixel in the camera region 400 may be smaller than the size of the B subpixel in the general area.

Referring to FIGS. 4B and 4C, the display may include a touchscreen panel layer 441 that generates an electric signal in response to a touch, a light-emitting layer 443 on which subpixels (e.g., OLEDs) and electrodes (e.g., anode and cathode) are formed, a driving circuit layer 445 on which a driving circuit (e.g., thin-film transistor and capacitor) for driving the pixels is formed, and a substrate (e.g., SI substrate or glass) 447. The light-emitting layer 443 may be configured as, for example, a thin-film encapsulation (TFE). The driving circuit layer 445, the light-emitting layer 443, and the touchscreen panel layer 441 may be formed in sequence on the substrate 447. The driving circuit may be electrically connected to one of the gate lines and one of the data lines configured in the display. The driving circuit may charge a capacitor with a data voltage supplied from a data driver (e.g., a display driver IC (DDI)) through the connected data line in response to a scan signal received from a gate driver (e.g., DDI) through the connected gate line. The driving circuit may control the amount of current supplied to a connected pixel depending on the data voltage charged to the capacitor. For example, the pixel may display visual information, based at least on the scan signal and the data signal.

Continuing with reference to FIGS. 4B and 4C, the subpixels 410-1, 410-2, 420-1, 420-2, 420-3, 420-5, and 420-7 may be formed on electrodes 451, 452, 453, 454, 455, 456, and 457, respectively. The electrodes 451, 452, 453, 454, 455, 456, and 457 may be connected to a driving circuit (not shown) through wires 461, 462, 463, 464, 465, 466, and 467, respectively. The electrodes 451, 452, 453, 454, 455, 456, and 457 may include an area in contact with the wires and an area in contact with the subpixels. Therefore, the electrodes 451, 452, 453, 454, 455, 456, and 457 may be asymmetrical with the corresponding subpixels. In addition, depending on the location of the area in contact the wires, the electrodes 451, 452, 453, 454, 455, 456, and 457 may not have the same or similar shape as the corresponding subpixels.

Unlike what are shown in FIG. 4B and FIG. 4C, when lower portions of the electrodes come into contact with the wires, the electrodes 451, 452, 453, 454, 455, 456, and 457 may be symmetrical with the corresponding subpixels.

Referring back to FIGS. 4A and 4B, the light transmitting areas 450-1, 450-2, 450-3, and 450-4 may be defined as an area surrounded by subpixels within the camera region 400. The area occupied by the light transmitting areas 450-1, 450-2, 450-3, and 450-4 in the camera region 400 may be determined by the distance between two R subpixels respectively positioned at two opposite edges, the distance between two G subpixels respectively positioned at two vertexes that are not adjacent, the distance between two G subpixels respectively positioned at two other vertexes that are not adjacent, and the distance between two B subpixels respectively positioned at two other opposite edges.

In an embodiment, light may be diffracted as it passes through the gaps between the subpixels in the camera region 400. The quality of an image captured by the UDC may be degraded due to the diffraction of light. According to an embodiment, a light blocking film may be further provided in the camera region 400, thereby preventing (or suppressing) diffraction of light due to a gap between the subpixels other than the light transmitting areas.

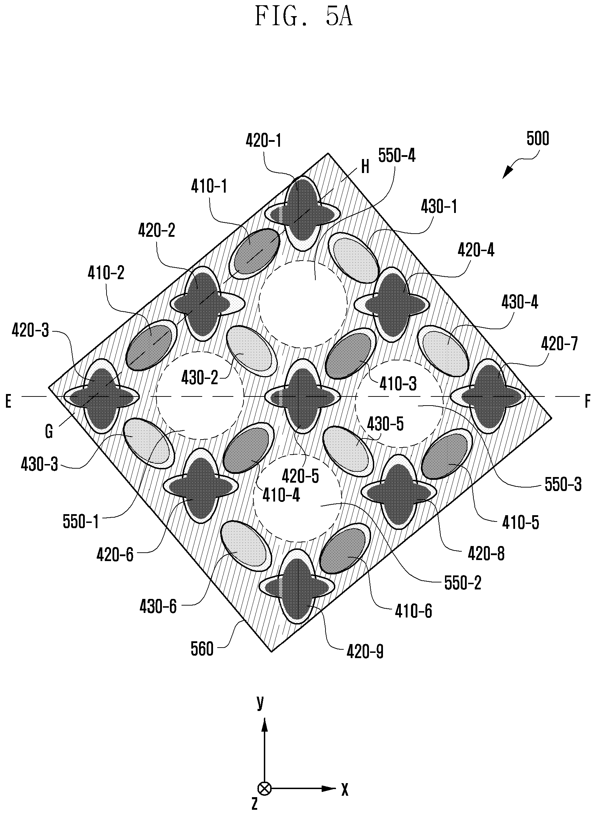

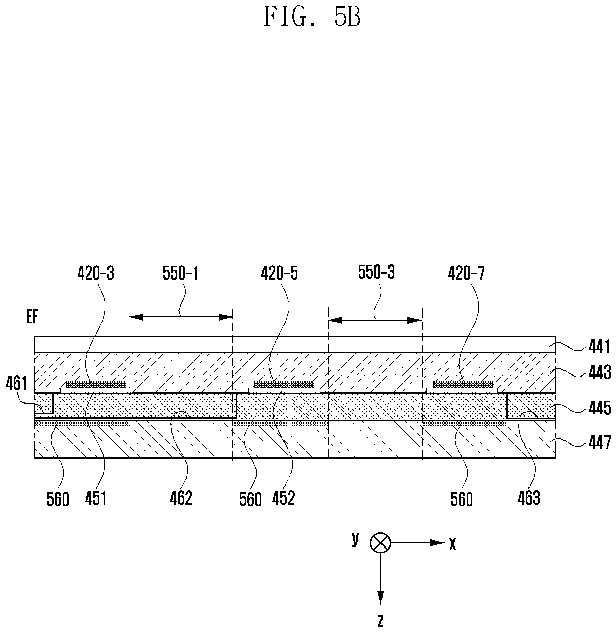

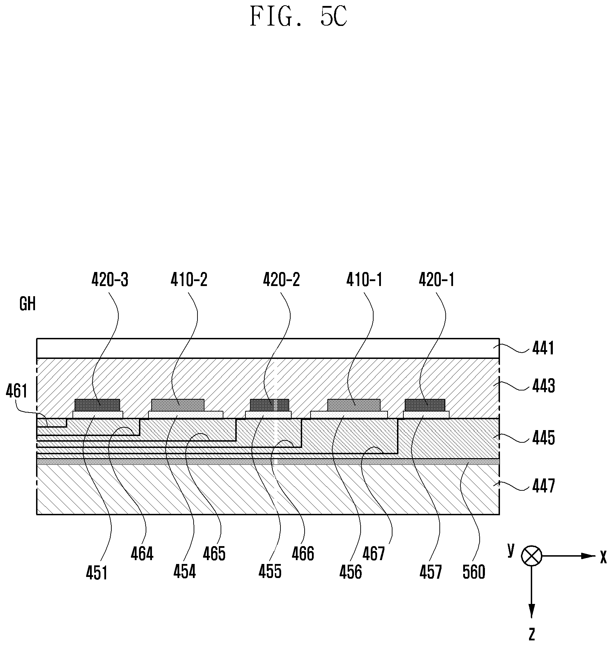

FIG. 5A is a diagram illustrating a pixel structure of a camera region 500 having a light blocking film according to an embodiment. FIG. 5B is a cross-sectional view of the camera region 500 taken along line EF in the z-axis direction in FIG. 5A. FIG. 5C is a cross-sectional view of the camera region 500 taken along line GH in the z-axis direction in FIG. 5A. The camera region 500 may correspond to, for example, a portion of the camera region 330 in FIG. 3A. The pixel structure of the camera region 330 may be the same as the pixel structure illustrated in FIG. 5A. Redundant descriptions with reference to FIGS. 4A to 4C above will be omitted or briefly made.

Referring to FIGS. 5A, 5B, and 5C, light transmitting areas 550-1, 550-2, 550-3, and 550-4 may be defined as an area surrounded by subpixels within the camera region 500. The area and shape occupied by the light transmitting areas 550-1, 550-2, 550-3, and 550-4 in the camera region 500 may be determined by the shape of a light blocking membrane 560. For example, the shapes of the light transmitting areas 550-1, 550-2, 550-3, and 550-4 may correspond to the shapes (e.g., a circle as illustrated) of areas where the light blocking membrane 560 is not formed. The sizes of the light transmitting areas 550-1, 550-2, 550-3, and 550-4 may correspond to the sizes of areas where the light blocking membrane 560 is not formed. The light blocking membrane 560 may be, for example, black in color for blocking light, and may be formed below the wires 461, 462, 463, 464, 465, and 466, 467, for example, between the driving circuit layer 445 and the substrate 447. The light blocking membrane 560 may be formed in all areas, excluding the light transmitting areas 550-1, 550-2, 550-3, and 550-4. Light is blocked in the areas other than the light transmitting areas 550-1, 550-2, 550-3, and 550-4, so that light diffraction due to the gaps between the subpixels may be prevented (or suppressed). Accordingly, the sizes of the subpixels may become smaller to increase the light transmitting areas. For example, the sizes of the subpixels in the camera region 500 in FIG. 5A may be smaller than the sizes of the subpixels in the camera region 400 in FIG. 4A.

According to an embodiment, an electronic device may include a camera; and a display disposed between a subject to be captured by the camera and the camera. The display may include a camera region (e.g., the camera region 400 in FIG. 4A or the camera region 500 in FIG. 5A) disposed above the camera when facing a front surface of the display. Subpixels may be disposed within the camera region, when facing the front surface of the display, such that a first G subpixel, a second G subpixel, a third G subpixel, and a fourth G subpixel are positioned at vertexes of a quadrangle, respectively, such that a first R subpixel and a second R subpixel are positioned at opposite first and second edges, respectively, in the quadrangle, such that a first B subpixel and a second B subpixel are positioned at opposite third and fourth edges, respectively, in the quadrangle, and such that no subpixel exists within the quadrangle. The first R subpixel and the second R subpixel may be configured in the shape of an ellipse. A long axis of the ellipse may extend parallel to the first edge in the first R subpixel. A long axis of the ellipse may extend parallel to the second edge in the second R subpixel. The first B subpixel and the second B subpixel may be configured in the shape of an ellipse. A long axis of the ellipse may extend parallel to the third edge in the first B subpixel. A long axis of the ellipse may extend parallel to the fourth edge in the second B subpixel. The first G subpixel, the second G subpixel, the third G subpixel, and the fourth G subpixel may be configured in the shape of a cross. Concave portions of the cross may face the first R subpixel, the second R subpixel, the first B subpixel, or the second B subpixel.

When facing the front surface of the display, the first G subpixel, the second G subpixel, the third G subpixel, and the fourth G subpixel may be formed on cross-shaped G subpixel electrodes, respectively. The first R subpixel and the second R subpixel may be formed on elliptical R subpixel electrodes, respectively. The first B subpixel and the second B subpixel may be formed on elliptical B subpixel electrodes, respectively.

A first radius of curvature R1 of a convex portion of the G subpixel electrode may be shorter than a second radius of curvature R2 of a long axis of the R subpixel electrode and a third radius of curvature R3 of a long axis of the B subpixel electrode.

The second radius of curvature R2 and the third radius of curvature R3 may be the same.

When facing the front surface of the display, the first G subpixel, the second G subpixel, the third G subpixel, the fourth G subpixel, the first R subpixel, the second R subpixel, the first B subpixel, and the second B subpixel may be formed such that entire portions thereof are respectively included within the corresponding subpixel electrodes.

The R subpixel electrode, the G subpixel electrode, and the B subpixel electrode may be anodes.

The display may include: a light-emitting layer on which subpixels are formed; a driving circuit layer formed under the light-emitting layer when facing the front surface of the display; a substrate formed under the driving circuit layer; and a light blocking membrane (e.g., the light blocking membrane 560 in FIG. 5A) formed in all areas, excluding a light transmitting area surrounded by subpixels, between the driving circuit layer and the substrate in the camera region.

The light transmitting area may be circular.

A size of the camera region and a position thereof on the display may be determined based on an angle of view of a lens of the camera.

The camera region may be positioned on the edge of the display.

RGB subpixels may be configured to constitute one pixel in the camera region. RGBG subpixels may be configured to constitute one pixel in a display area outside the camera region.

A size of the G subpixel in the camera region may be larger than a size of the G subpixel in the display area outside the camera region.

A size of the R subpixel in the camera region may be the same as a size of the R subpixel in the display area outside the camera region. A size of the B subpixel in the camera region may be the same as a size of the B subpixel in the display area outside the camera region.

A size of the R subpixel in the camera region may be smaller than a size of the R subpixel in the display area outside the camera region. A size of the B subpixel in the camera region may be smaller than a size of the B subpixel in the display area outside the camera region.

According to an embodiment, an electronic device may include a camera; and a display disposed between a subject to be captured by the camera and the camera. The display may include a camera region (e.g., the camera region 500 in FIG. 5A) disposed above the camera when facing a front surface of the display. Subpixels may be disposed within the camera region, when facing the front surface of the display, such that a first G subpixel, a second G subpixel, a third G subpixel, and a fourth G subpixel are positioned at vertexes of a quadrangle, respectively, such that a first R subpixel and a second R subpixel are positioned at opposite first and second edges, respectively, in the quadrangle, such that a first B subpixel and a second B subpixel are positioned at opposite third and fourth edges, respectively, in the quadrangle, and such that no subpixel exists within the quadrangle. The first R subpixel and the second R subpixel may be configured in the shape of an ellipse. A long axis of the ellipse may extend parallel to the first edge in the first R subpixel. A long axis of the ellipse may extend parallel to the second edge in the second R subpixel. The first B subpixel and the second B subpixel may be configured in the shape of an ellipse. A long axis of the ellipse may extend parallel to the third edge in the first B subpixel. A long axis of the ellipse may extend parallel to the fourth edge in the second B subpixel. The first G subpixel, the second G subpixel, the third G subpixel, and the fourth G subpixel may be configured in the shape of a cross. Concave portions of the cross may face the first R subpixel, the second R subpixel, the first B subpixel, or the second B subpixel. When facing the front surface of the display, a light blocking membrane (e.g., the light blocking membrane 560 in FIG. 5A) may be formed in all areas, excluding a light transmitting area surrounded by subpixels, under the subpixels within the camera region.

When facing the front surface of the display, the first G subpixel, the second G subpixel, the third G subpixel, and the fourth G subpixel may be formed on cross-shaped G subpixel electrodes, respectively. The first R subpixel and the second R subpixel may be formed on elliptical R subpixel electrodes, respectively. The first B subpixel and the second B subpixel may be formed on elliptical B subpixel electrodes, respectively.

A first radius of curvature R1 of a convex portion of the G subpixel electrode may be shorter than a second radius of curvature R2 of a long axis of the R subpixel electrode and a third radius of curvature R3 of a long axis of the B subpixel electrode.

A size of the camera region and a position thereof on the display may be determined based on an angle of view of a lens of the camera.

The camera region may be positioned on the edge of the display.

RGB subpixels may be configured to constitute one pixel in the camera region. RGBG subpixels may be configured to constitute one pixel in a display area outside the camera region.

## Claims

1. An electronic device (101) comprising:
a display (160); and
a camera (180) disposed under the display (160) when facing a front surface of the display (160),
wherein the display (160) comprises a camera region (400) disposed above the camera (180) when facing a front surface of the display (160),
wherein subpixels are disposed within the camera region (400), when facing the front surface of the display (160), such that a first G subpixel (420-1), a second G subpixel (420-2), a third G subpixel (420-4), and a fourth G subpixel (420-5) are positioned at vertexes of a quadrangle, respectively, such that a first R subpixel (410-1) and a second R subpixel (410-3) are positioned at opposite first and second edges, respectively, in the quadrangle, and such that a first B subpixel (430-1) and a second B subpixel (430-2) are positioned at opposite third and fourth edges, respectively, in the quadrangle, and such that no subpixel exists within the quadrangle,
wherein the first R subpixel (410-1) and the second R subpixel (410-3) are configured in the shape of an ellipse such that a long axis of the ellipse extends parallel to the first edge in the first R subpixel (410-1) and such that a long axis of the ellipse extends parallel to the second edge in the second R subpixel (410-3),
wherein the first B subpixel (430-1) and the second B subpixel (430-2) are configured in the shape of an ellipse such that a long axis of the ellipse extends parallel to the third edge in the first B subpixel (430-1) and such that a long axis of the ellipse extends parallel to the fourth edge in the second B subpixel (430-2), and
wherein the first G subpixel (420-1), the second G subpixel (420-2), the third G subpixel (420-4), and the fourth G subpixel (420-5) are configured in the shape of a cross such that concave portions of the cross face the first R subpixel (410-1), the second R subpixel (410-3), the first B subpixel (430-1), or the second B subpixel (430-2).

2. The electronic device (101) of claim 1,
wherein, when facing the front surface of the display (160),
the first G subpixel (420-1), the second G subpixel (420-2), the third G subpixel (420-4), and the fourth G subpixel (420-5) are formed on cross-shaped G subpixel electrodes, respectively,
the first R subpixel (410-1) and the second R subpixel (410-3) are formed on elliptical R subpixel electrodes, respectively, and
the first B subpixel (430-1) and the second B subpixel (430-2) are formed on elliptical B subpixel electrodes, respectively.

3. The electronic device (101) of claim 2,
wherein a first radius of curvature of a convex portion of the G subpixel electrode is shorter than a second radius of curvature of a long axis of the R subpixel electrode and a third radius of curvature of a long axis of the B subpixel electrode.

4. The electronic device (101) of claim 3,
wherein the second radius of curvature and the third radius of curvature are the same.

5. The electronic device (101) of claim 2,
wherein, when facing the front surface of the display (160),
the first G subpixel (420-1), the second G subpixel (420-2), the third G subpixel (420-4), the fourth G subpixel (420-5), the first R subpixel (410-1), the second R subpixel (410-3), the first B subpixel (430-1), and the second B subpixel (430-2) are formed such that entire portions thereof are respectively included within the corresponding subpixel electrodes.

6. The electronic device (101) of claim 2,
wherein the R subpixel electrode, the G subpixel electrode, and the B subpixel electrode are anodes.

7. The electronic device (101) of any one of claims 1 to 6,
wherein the display (160) comprises:
a light-emitting layer (443) on which subpixels are formed;
a driving circuit layer (445) formed under the light-emitting layer (443) when facing the front surface of the display (160);
a substrate (447) formed under the driving circuit layer (445); and
a light blocking membrane (560) formed in all areas, excluding a light transmitting area surrounded by subpixels, between the driving circuit layer (445) and the substrate (447) in the camera region (400).

8. The electronic device (101) of claim 7,
wherein the light transmitting area is circular.

9. The electronic device (101) of any one of claims 1 to 8,
wherein a size of the camera region (400) and a position thereof on the display (160) are determined based on an angle of view of a lens of the camera (160).

10. The electronic device (101) of any one of claims 1 to 8,
wherein the camera region (400) is positioned on the edge of the display (160).

11. The electronic device (101) of any one of claims 1 to 8,
wherein RGB subpixels are configured to constitute one pixel in the camera region (400), and
wherein RGBG subpixels are configured to constitute one pixel in a display area outside the camera region (400).

12. The electronic device (101) of claim 11,
wherein a size of the G subpixel in the camera region (400) is larger than a size of the G subpixel in the display area outside the camera region (400).

13. The electronic device (101) of claim 12,
wherein a size of the R subpixel in the camera region (400) is the same as a size of the R subpixel in the display area outside the camera region (400), and
wherein a size of the B subpixel in the camera region (400) is the same as a size of the B subpixel in the display area outside the camera region (400).

14. The electronic device (101) of claim 12,
wherein a size of the R subpixel in the camera region (400) is smaller than a size of the R subpixel in the display area outside the camera region (400), and
wherein a size of the B subpixel in the camera region (400) is smaller than a size of the B subpixel in the display area outside the camera region (400).

15. The electronic device (101) of any one of claims 1 to 6,
wherein, when facing the front surface of the display (160), a light blocking membrane (560) is formed in all areas, excluding a light transmitting area surrounded by subpixels, under the subpixels within the camera region (400).

## Patentansprüche

1. Elektronische Vorrichtung (101), umfassend:
eine Anzeige (160); und
eine Kamera (180), die unterhalb der Anzeige (160) angeordnet ist, wenn man auf eine Frontfläche der Anzeige (160) blickt,
wobei die Anzeige (160) einen Kamerabereich (400) umfasst, der oberhalb der Kamera (180) angeordnet ist, wenn man auf eine Frontfläche der Anzeige (160) blickt,
wobei, wenn man auf die Frontfläche der Anzeige (160) blickt, Subpixel innerhalb des Kamerabereichs (400) so angeordnet sind, dass ein erstes G-Subpixel (420-1), ein zweites G-Subpixel (420-2), ein drittes G-Subpixel (420-4) und ein viertes G-Subpixel (420-5) jeweils an den Eckpunkten eines Vierecks positioniert sind, dass ein erstes R-Subpixel (410-1) und ein zweites R-Subpixel (410-3) jeweils an einer ersten bzw. einer zweiten Kante im Viereck, die einander gegenüberliegen, positioniert sind, und dass ein erstes B-Subpixel (430-1) und ein zweites B-Subpixel (430-2) jeweils an einer dritten bzw. einer vierten Kante im Viereck, die einander gegenüberliegen, positioniert sind, so dass innerhalb des Vierecks kein Subpixel vorhanden ist,
wobei das erste R-Subpixel (410-1) und das zweite R-Subpixel (410-3) in Form einer Ellipse konfiguriert sind, derart, dass sich eine lange Achse der Ellipse parallel zur ersten Kante im ersten R-Subpixel (410-1) erstreckt und dass sich eine lange Achse der Ellipse parallel zur zweiten Kante im zweiten R-Subpixel (410-3) erstreckt,
wobei das erste B-Subpixel (430-1) und das zweite B-Subpixel (430-2) in Form einer Ellipse konfiguriert sind, derart, dass sich eine Lange Achse der Ellipse parallel zur dritten Kante im ersten B-Subpixel (430-1) erstreckt und dass sich eine Lange Achse der Ellipse parallel zur vierten Kante im zweiten B-Subpixel (430-2) erstreckt, und
wobei das erste G-Subpixel (420-1), das zweite G-Subpixel (420-2), das dritte G-Subpixel (420-4) und das vierte G-Subpixel (420-5) in Form eines Kreuzes konfiguriert sind, derart, dass konkave Abschnitte des Kreuzes dem ersten R-Subpixel (410-1), dem zweiten R-Subpixel (410-3), dem ersten B-Subpixel (430-1) oder dem zweiten B-Subpixel (430-2) zugewandt sind.

2. Elektronische Vorrichtung (101) nach Anspruch 1,
wobei, wenn man auf die Frontfläche der Anzeige (160) blickt,
das erste G-Subpixel (420-1), das zweite G-Subpixel (420-2), das dritte G-Subpixel (420-4) und das vierte G-Subpixel (420-5) jeweils auf kreuzförmigen G-Subpixelelektroden ausgebildet sind,
das erste R-Subpixel (410-1) und das zweite R-Subpixel (410-3) jeweils auf elliptischen R-Subpixelelektroden ausgebildet sind und
das erste B-Subpixel (430-1) und das zweite B-Subpixel (430-2) jeweils auf elliptischen B-Subpixelelektroden ausgebildet sind.

3. Elektronische Vorrichtung (101) nach Anspruch 2,
wobei ein erster Krümmungsradius eines konvexen Abschnitts der G-Subpixelelektrode kürzer ist als ein zweiter Krümmungsradius einer langen Achse der R-Subpixelelektrode und ein dritter Krümmungsradius einer langen Achse der B-Subpixelelektrode.

4. Elektronische Vorrichtung (101) nach Anspruch 3,
wobei der zweite Krümmungsradius und der dritte Krümmungsradius gleich sind.

5. Elektronische Vorrichtung (101) nach Anspruch 2,
wobei, wenn man auf die Frontfläche der Anzeige (160) blickt,
das erste G-Subpixel (420-1), das zweite G-Subpixel (420-2), das dritte G-Subpixel (420-4), das vierte G-Subpixel (420-5), das erste R-Subpixel (410-1), das zweite R-Subpixel (410-3), das erste B-Subpixel (430-1) und das zweite B-Subpixel (430-2) so ausgebildet sind, dass ihre gesamten Abschnitte jeweils innerhalb der entsprechenden Subpixelelektroden enthalten sind.

6. Elektronische Vorrichtung (101) nach Anspruch 2,
wobei die R-Subpixelelektrode, die G-Subpixelelektrode und die B-Subpixelelektrode Anoden sind.

7. Elektronische Vorrichtung (101) nach einem der Ansprüche 1 bis 6,
wobei die Anzeige (160) Folgendes umfasst:
eine lichtemittierende Schicht (443), auf der Subpixel ausgebildet sind;
eine Treiberschaltungsschicht (445), die unter der lichtemittierenden Schicht (443) ausgebildet ist, wenn man auf die Frontfläche der Anzeige (160) blickt;
ein Substrat (447), das unter der Treiberschaltungsschicht (445) ausgebildet ist; und
eine lichtblockierende Membran (560), die in allen Bereichen, mit Ausnahme eines von Subpixeln umgebenen lichtdurchlässigen Bereichs, zwischen der Treiberschaltungsschicht (445) und dem Substrat (447) im Kamerabereich (400) ausgebildet ist.

8. Elektronische Vorrichtung (101) nach Anspruch 7,
wobei der lichtdurchlässige Bereich kreisförmig ist.

9. Elektronische Vorrichtung (101) nach einem der Ansprüche 1 bis 8,
wobei eine Größe des Kamerabereichs (400) und dessen Position auf der Anzeige (160) auf der Grundlage eines Blickwinkels einer Linse der Kamera (160) bestimmt werden.

10. Elektronische Vorrichtung (101) nach einem der Ansprüche 1 bis 8,
wobei der Kamerabereich (400) am Rand der Anzeige (160) positioniert ist.

11. Elektronische Vorrichtung (101) nach einem der Ansprüche 1 bis 8,
wobei RGB-Subpixel dazu konfiguriert sind, ein Pixel im Kamerabereich (400) zu bilden, und
wobei RGBG-Subpixel dazu konfiguriert sind, ein Pixel in einem Anzeigebereich außerhalb des Kamerabereichs (400) zu bilden.

12. Elektronische Vorrichtung (101) nach Anspruch 11,
wobei eine Größe des G-Subpixels im Kamerabereich (400) größer ist als eine Größe des G-Subpixels im Anzeigebereich außerhalb des Kamerabereichs (400).

13. Elektronische Vorrichtung (101) nach Anspruch 12,
wobei eine Größe des R-Subpixels im Kamerabereich (400) gleich einer Größe des R-Subpixels im Anzeigebereich außerhalb des Kamerabereichs (400) ist, und
wobei eine Größe des B-Subpixels im Kamerabereich (400) gleich einer Größe des B-Subpixels im Anzeigebereich außerhalb des Kamerabereichs (400) ist.

14. Elektronische Vorrichtung (101) nach Anspruch 12,
wobei eine Größe des R-Subpixels im Kamerabereich (400) kleiner ist als eine Größe des R-Subpixels im Anzeigebereich außerhalb des Kamerabereichs (400), und
wobei eine Größe des B-Subpixels im Kamerabereich (400) kleiner ist als eine Größe des B-Subpixels im Anzeigebereich außerhalb des Kamerabereichs (400).

15. Elektronische Vorrichtung (101) nach einem der Ansprüche 1 bis 6,
wobei, wenn man auf die Frontfläche der Anzeige (160) blickt, eine lichtblockierende Membran (560) in allen Bereichen unter den Subpixeln innerhalb des Kamerabereichs (400) ausgebildet ist, mit Ausnahme eines von Subpixeln umgebenen lichtdurchlässigen Bereichs.

## Revendications

1. Dispositif électronique (101) comprenant :
un écran (160) ; et
une caméra (180) placée sous l'écran (160) lorsqu'on fait face à une surface avant de l'écran (160),
dans lequel l'écran (160) comprend une région de caméra (400) placée au-dessus de la caméra (180) lorsqu'on fait face à la surface avant de l'écran (160),
dans lequel des sous-pixels sont placés dans la région de caméra (400), lorsqu'on fait face à la surface avant de l'écran (160), de telle sorte qu'un premier sous-pixel G (420-1), un deuxième sous-pixel G (420-2), un troisième sous-pixel G (420-4) et un quatrième sous-pixel G (420-5) sont positionnés respectivement aux sommets d'un quadrilatère, de telle sorte qu'un premier sous-pixel R (410-1) et un deuxième sous-pixel R (410-3) sont positionnés respectivement sur des première et deuxième arêtes opposées dans le quadrilatère, et de telle sorte qu'un premier sous-pixel B (430-1) et un deuxième sous-pixel B (430-2) sont positionnés respectivement sur des troisième et quatrième arêtes opposées dans le quadrilatère, et de telle sorte qu'aucun sous-pixel n'existe à l'intérieur du quadrilatère,
dans lequel le premier sous-pixel R (410-1) et le deuxième sous-pixel R (410-3) sont configurés sous forme d'une ellipse de telle sorte qu'un grand axe de l'ellipse s'étend parallèlement à la première arête dans le premier sous-pixel R (410-1) et de telle sorte qu'un grand axe de l'ellipse s'étend parallèlement à la deuxième arête dans le deuxième sous-pixel R (410-3),
dans lequel le premier sous-pixel B (430-1) et le deuxième sous-pixel B (430-2) sont configurés sous forme d'une ellipse de telle sorte qu'un grand axe de l'ellipse s'étend parallèlement à la troisième arête dans le premier sous-pixel B (430-1) et de telle sorte qu'un grand axe de l'ellipse s'étend parallèlement à la quatrième arête dans le deuxième sous-pixel B (430-2), et
dans lequel le premier sous-pixel G (420-1), le deuxième sous-pixel G (420-2), le troisième sous-pixel G (420-4) et le quatrième sous-pixel G (420-5) sont configurés sous forme d'une croix de telle sorte que des parties concaves de la croix font face au premier sous-pixel R (410-1), au deuxième sous-pixel R (410-3), au premier sous-pixel B (430-1) ou au deuxième sous-pixel B (430-2).

2. Dispositif électronique (101) selon la revendication 1,
dans lequel, lorsqu'on fait face à la surface avant de l'écran (160),
le premier sous-pixel G (420-1), le deuxième sous-pixel G (420-2), le troisième sous-pixel G (420-4) et le quatrième sous-pixel G (420-5) sont formés respectivement sur des électrodes de sous-pixels G en forme de croix,
le premier sous-pixel R (410-1) et le deuxième sous-pixel R (410-3) sont formés respectivement sur des électrodes de sous-pixels R de forme elliptique, et
le premier sous-pixel B (430-1) et le deuxième sous-pixel B (430-2) sont formés respectivement sur des électrodes de sous-pixels B de forme elliptique.

3. Dispositif électronique (101) selon la revendication 2,
dans lequel un premier rayon de courbure d'une partie convexe de l'électrode de sous-pixel G est inférieur à un deuxième rayon de courbure d'un grand axe de l'électrode de sous-pixel R et à un troisième rayon de courbure d'un grand axe de l'électrode de sous-pixel B.

4. Dispositif électronique (101) selon la revendication 3,
dans lequel le deuxième rayon de courbure et le troisième rayon de courbure sont identiques.

5. Dispositif électronique (101) selon la revendication 2,
dans lequel, lorsqu'on fait face à la surface avant de l'écran (160),
le premier sous-pixel G (420-1), le deuxième sous-pixel G (420-2), le troisième sous-pixel G (420-4), le quatrième sous-pixel G (420-5), le premier sous-pixel R (410-1), le deuxième sous-pixel R (410-3), le premier sous-pixel B (430-1) et le deuxième sous-pixel B (430-2) sont formés de telle sorte que leurs portions entières sont respectivement incluses dans les électrodes de sous-pixels correspondantes.

6. Dispositif électronique (101) selon la revendication 2,
dans lequel l'électrode de sous-pixel R, l'électrode de sous-pixel G et l'électrode de sous-pixel B sont des anodes.

7. Dispositif électronique (101) selon l'une quelconque des revendications 1 à 6,
dans lequel l'écran (160) comprend :
une couche émissive de lumière (443) sur laquelle des sous-pixels sont formés ;
une couche de circuit de commande (445) formée sous la couche émissive de lumière (443) lorsqu'on fait face à la surface avant de l'écran (160) ;
un substrat (447) formé sous la couche de circuit de commande (445) ; et
une membrane de blocage de lumière (560) formée dans toutes les zones, à l'exclusion d'une zone de transmission de lumière entourée par des sous-pixels, entre la couche de circuit de commande (445) et le substrat (447) dans la région de caméra (400).

8. Dispositif électronique (101) selon la revendication 7,
dans lequel la zone de transmission de lumière est circulaire.

9. Dispositif électronique (101) selon l'une quelconque des revendications 1 à 8,
dans lequel une taille de la région de caméra (400) et une position de celle-ci sur l'écran (160) sont déterminées sur la base d'un angle de champ d'un objectif de la caméra (160).

10. Dispositif électronique (101) selon l'une quelconque des revendications 1 à 8,
dans lequel la région de caméra (400) est positionnée sur un bord de l'écran (160).

11. Dispositif électronique (101) selon l'une quelconque des revendications 1 à 8,
dans lequel des sous-pixels RGB sont configurés pour constituer un pixel dans la région de caméra (400), et
dans lequel des sous-pixels RGBG sont configurés pour constituer un pixel dans une zone d'affichage située à l'extérieur de la région de caméra (400).

12. Dispositif électronique (101) selon la revendication 11,
dans lequel une taille du sous-pixel G dans la région de caméra (400) est supérieure à une taille du sous-pixel G dans la zone d'affichage située à l'extérieur de la région de caméra (400).

13. Dispositif électronique (101) selon la revendication 12,
dans lequel une taille du sous-pixel R dans la région de caméra (400) est identique à une taille du sous-pixel R dans la zone d'affichage située à l'extérieur de la région de caméra (400), et
dans lequel une taille du sous-pixel B dans la région de caméra (400) est identique à une taille du sous-pixel B dans la zone d'affichage située à l'extérieur de la région de caméra (400).

14. Dispositif électronique (101) selon la revendication 12,
dans lequel une taille du sous-pixel R dans la région de caméra (400) est inférieure à une taille du sous-pixel R dans la zone d'affichage située à l'extérieur de la région de caméra (400), et
dans lequel une taille du sous-pixel B dans la région de caméra (400) est inférieure à une taille du sous-pixel B dans la zone d'affichage située à l'extérieur de la région de caméra (400).

15. Dispositif électronique (101) selon l'une quelconque des revendications 1 à 6,
dans lequel, lorsqu'on fait face à la surface avant de l'écran (160), une membrane de blocage de lumière (560) est formée dans toutes les zones, à l'exclusion d'une zone de transmission de lumière entourée par des sous-pixels, sous les sous-pixels situés dans la région de caméra (400).
